# EUROPÄISCHE PATENTSCHRIFT

(11) **EP 3 188 581 B1**
(45) Veröffentlichungstag und Bekanntmachung des Hinweises auf die Patenterteilung: **12.09.2018**
(21) Anmeldenummer: 16204226.1
(22) Anmeldetag: 15.12.2016
(51) Int. Cl.: H05K 9/00, H02G 3/08, H02G 15/12, H05K 1/02, H04B 1/08, H04B 1/03, H03F 3/189, H05K 5/04

(54) **HOCHFREQUENZVERSTÄRKER FÜR KOAXIALNETZWERKE**
HIGH FREQUENCY AMPLIFIER FOR COAXIAL NETWORKS
AMPLIFICATEUR À HAUTE FRÉQUENCE POUR RÉSEAUX COAXIAUX

(30) Priorität: 29.12.2015 DE 102015122913
(43) Veröffentlichungstag der Anmeldung: 05.07.2017
(73) Patentinhaber: KATHREIN-Werke KG, 83022 Rosenheim (DE)
(72) Erfinder: ZIEGLER, Alexander, 83093 Bad Endorf (DE); HELBICH, Peter, 83059 Kolbermoor (DE); NEIDERHELL, Johannes, 83064 Raubling (DE)
(74) Vertreter: Flach Bauer Stahl Patentanwälte Partnerschaft mbB

(56) Entgegenhaltungen:
- EP-A1- 0 393 236
- WO-A1-93/17535
- WO-A1-2015/105593
- DE-A1-102013 106 771

## Beschreibung

Die Erfindung betrifft einen Hochfrequenzverstärker für Koaxialnetzwerke. Derartige Koaxialnetzwerke werden häufig eingesetzt, um verschiedene Gebäudeteile mit elektrischen Informationen zu versorgen. Hierzu gehören die klassischen Kabelnetzwerke, die zum Übertragen von TV- bzw. Radiosignalen und Internetdaten genutzt werden. Die Endteilnehmer sind dabei an ein Koaxialnetzwerk angeschlossen. Über dieses Koaxialnetzwerk werden die Daten bidirektional übertragen. Hier stehen unterschiedliche Frequenzbereiche zur Verfügung. Derartige Koaxialnetzwerke können eine Länge aufweisen, die es erforderlich macht, dass das Signal in regelmäßigen Abständen verstärkt werden muss. Dies trifft sowohl auf die Signale zu, die von dem Kabelnetzbetreiber kommen und in Richtung der Endteilnehmer übertragen werden, als auch auf die Signale, die von den Endteilnehmern in Richtung des Kabelnetzbetreibers übertragen werden. Hierzu wird der erfindungsgemäße Hochfrequenzverstärker verwendet.

Bei derartigen Kabelnetzen ist es an vielen Stellen auch so, dass eine Umsetzung von einem optischen Signal auf ein elektrisches Signal erfolgt. An bestimmten Anschlussstellen enden Glasfaserkabel, wobei von dort die letzten Meter zu den Endteilnehmern über Koaxialkabel überbrückt werden. Auch eine solche Umsetzung von einem optischen Signal auf ein elektrisches Signal kann mittels des erfindungsgemäßen Hochfrequenzverstärkers erreicht werden.

Grundsätzlich kann der erfindungsgemäße Hochfrequenzverstärker zum Verstärken allen Signalen verwendet werden, die über Koaxialkabel übertragen werden. So kann der erfindungsgemäße Hochfrequenzverstärker auch im Mobilfunkbereich eingesetzt werden, um Signale, die einer Basisstation zugeführt werden, zu verstärken.

Ein derartiger Hochfrequenzverstärker umfasst verschiedene elektrische Funktionseinheiten. Einige dieser Funktionseinheiten sind in dem Vorwärtspfad, andere in dem Rückwärtspfad angeordnet. Einige dieser Einheiten dienen zum Verstärken, andere zum Verarbeiten des zu übertragenden elektrischen Signals. Damit der Hochfrequenzverstärker möglichst zuverlässig funktioniert, soll eine unerwünschte Kopplung zwischen den einzelnen Funktionseinheiten auf ein Minimum reduziert werden.

Die DE 10 2013 215 843 B3 beschreibt eine Anordnung zum Kühlen von elektrischen Bauelementen mittels eines Fluids, wobei die Anordnung insbesondere in Magnetresonaztomographen eingesetzt wird. Auf einer Leiterplatte ist ein elektrisches Bauelement angeordnet, das durch Wände umgrenzt umgrenzt wird, wobei die Wände senkrecht und parallel zur Leiterplatte angeordnet sind. Dadurch ist ein Kanal gebildet, durch den das Fluid strömen kann. An einer dieser Wände, ist auf der Seite, die dem Kanal abgewandt ist, ein weiteres elektrisches Bauteil angeordnet, sodass über einen Kanal mehrere elektrische Bauteile kühlbar sind.

Die US 2015/0048675 A1 zeigt ein Gehäuse, in dem elektrische Bauteile angeordnet sind. Das Gehäuse ist durch einen Gehäusedeckel abgeschlossen. Das Gehäuse umfasst neben einem Gehäuseboden und einer umlaufenden Gehäusewand noch Zwischenwände, wodurch voneinander getrennte Gehäusekammern entstehen. Die elektrischen Bauteile sind voneinander so beabstandet auf einer Leiterplatte angeordnet, dass diese in unterschiedliche Gehäusekammern liegen bzw. hineinragen. Die Leiterplatte umfasst eine Masselage, die galvanisch über eine Schraubverbindung mit dem Gehäuse verbunden wird.

Aus der WO 2015/105593 A1 ist ein Gehäuse für ein elektrisches Gerät bekannt. Das Gehäuse umfasst einen Gehäuseboden, eine umlaufende Gehäusewand und einen Gehäusedeckel. In dem Gehäuse ist eine Leiterplatte angeordnet, die verschiedene elektrische Bauteile aufweist. Eine Trenneinrichtung, die mehrere Trennwände umfasst, die senkrecht zur Leiterplatte angeordnet sind, wird auf die Leiterplatte aufgesetzt. Dadurch werden unterschiedliche Kammern gebildet, die elektromagnetisch voneinander getrennt sind. Die elektrischen Bauteile sind dabei zumindest teilweise in unterschiedlichen Kammern angeordnet.

Die WO 2009/066931 A1 zeigt einen Tuner, der ein Gehäuse aufweist. Das Gehäuse umfasst einen Gehäuseboden, eine umlaufende Gehäusewand und einen Gehäusedeckel. In dem Gehäuse ist eine Leiterplatte angeordnet, auf der verschiedene elektrische Bauteile angebracht sind. Mehrere Trennwände, die senkrecht zur Leiterplatte angeordnet sind, werden auf die Leiterplatte aufgesetzt. Sie umfassen eine Halteeinrichtung, über die sie an der umlaufenden Gehäusewand befestigt, bzw. in diese eingehängt werden können. Dadurch werden unterschiedliche Kammern gebildet, die elektromagnetisch voneinander getrennt sind. Die elektrischen Bauteile sind dabei zumindest teilweise in unterschiedlichen Kammern angeordnet.

Aus der CN 101 951 267 A ist ein Gehäuse bekannt, in dem elektrische Bauteile angeordnet sind. Das Gehäuse wird durch einen Gehäusedeckel abgeschlossen. Das Gehäuse umfasst neben einem Gehäuseboden und einer umlaufenden Gehäusewand noch Zwischenwände, wodurch voneinander getrennte Gehäusekammern entstehen. Eine Leiterplatte überdeckt dabei diese Zwischenwände, wobei mehrere Leiterplatten übereinander, aber beabstandet zueinander angeordnet sind und jeweils mehrere Gehäusekammern überdecken.

Die WO 93/17535 A1 zeigt ein mehrteiliges Gehäuse für Steuergeräte. Leistungsbauelemente und Steuerbauelemente sind auf einer Leiterplatte angeordnet. Diese umfasst eine umlaufenden Kaschierung aus elektrisch und wärmeleitendem Material, wobei die Leiterplatte im Bereich dieser Kaschierungen, die miteinander elektrisch leitend verbunden sind, zwischen den Gehäusehälften eingespannt wird und die Leistungsbauelemente wärmeleitend mit dieser Kaschierung kontaktiert sind, während störstrahlintensive oder störstrahlempfindliche Steuerelemente innerhalb von der Wand vorstehenden Stutzen eingeschlossen sind.

Aus der DE 10 2013 106 771 A1 ist ein Gehäuse für elektronische Bauelemente bekannt, das zumindest einen Gehäusekörper und einen Gehäusedeckel aufweist, wobei der Gehäusekörper zumindest einen Hohlraum umfasst, welcher mit zumindest einem Gehäusedeckel verschließbar ist. Das Gehäuse weist außerdem einen weiteren Hohlraum auf, der ebenfalls in dem Gehäusekörper angeordnet ist und zur Unterbringung eines Netzteils dient.

Die EP 0 393 236 A1 zeigt ein Gehäuse, welches mehrere voneinander getrennte Kammern umfasst, in denen elektrische Bauelemente angeordnet sind.

Aus der DE 1 791 204 A1 ist ein elektrisches Gerät bekannt, bei welchem einzelne elektrische Funktionseinheiten auf eigenen Leiterplatten in ein gemeinsames Gehäuse eingesetzt werden. Die Leiterplatten sind dabei beabstandet zu dem Gehäuseboden angeordnet. Die einzelnen elektrischen Funktionseinheiten sind voneinander durch Bleche entkoppelt. Diese Bleche werden nachträglich eingesetzt.

Nachteilig an der DE 1 791 204 A1 ist, dass der Aufbau des elektrischen Geräts sehr aufwändig ist und nicht automatisiert erfolgen kann. Dadurch ergeben sich hohe Kosten für die Herstellung des elektrischen Geräts.

Es ist daher die Aufgabe der hier vorliegenden Erfindung, ein Hochfrequenzverstärker für Koaxialnetzwerke zu schaffen, welches gegenüber dem Stand der Technik einfacher herzustellen ist und bei welchem die einzelnen elektrischen Funktionseinheiten optimal voneinander abgeschirmt sind.

Die Aufgabe wird durch den erfindungsgemäßen Hochfrequenzverstärker für Koaxialnetzwerke gemäß dem unabhängigen Anspruch 1 gelöst. In den Unteransprüchen sind vorteilhafte Weiterbildungen des Hochfrequenzverstärkers für Koaxialnetzwerke angegeben.

Der erfindungsgemäße Hochfrequenzverstärker für Koaxialnetzwerke weist ein Hochfrequenzgehäuse auf, das einen Gehäusekörper und einen Gehäusedeckel umfasst. Der Gehäusekörper weist einen Gehäuseboden und eine zwischen dem Gehäuseboden und dem Gehäusedeckel umlaufende Gehäusewand auf, wodurch ein Aufnahmeraum gebildet ist und wodurch der Gehäusedeckel von dem Gehäuseboden beabstandet ist. Der Gehäusekörper umfasst eine Vielzahl von bodenseitigen Abstütztrennwänden, die galvanisch mit dem Gehäuseboden verbunden und einteilig mit diesem ausgebildet sind. Die Vielzahl von bodenseitigen Abstütztrennwänden erstrecken sich in axialer Richtung vom Gehäuseboden in Richtung des Gehäusedeckels, wodurch mehrere bodenseitige Hochfrequenzkammern, die gegeneinander isoliert sind, gebildet sind. Sie enden natürlich in einem Abstand vor dem Gehäusedeckel. Der Hochfrequenzverstärker umfasst außerdem eine Leiterplatte, die mehrere elektrische Funktionseinheiten aufweist. Auf einer Unterseite der Leiterplatte sind zwischen den elektrischen Funktionseinheiten mehrere unterseitige Massebereiche angeordnet. Die Leiterplatte liegt überwiegend mit ihren unterseitigen Massebereichen auf der Vielzahl von bodenseitigen Abstütztrennwänden auf, wodurch die einzelnen elektrischen Funktionseinheiten in Richtung des Gehäusebodens durch die bodenseitigen Hochfrequenzkammern voneinander getrennt sind. Der Hochfrequenzverstärker umfasst außerdem einen Zwischendeckel, der eine Vielzahl von deckelseitigen Abstütztrennwänden umfasst, die galvanisch mit dem Zwischendeckel verbunden und einteilig mit diesem ausgebildet sind. Die Vielzahl von deckelseitigen Abstütztrennwänden erstrecken sich in axialer Richtung vom Zwischendeckel in Richtung des Gehäusebodens, wodurch mehrere deckelseitige Hochfrequenzkammern gebildet sind. Sie enden natürlich in einem Abstand vor dem Gehäuseboden. Mehrere oberseitige Massebereiche sind auf einer Oberseite der Leiterplatte zwischen den elektrischen Funktionseinheiten angeordnet. Die deckelseitigen Abstütztrennelemente liegen überwiegend auf diesen oberseitigen Massebereichen der Leiterplatte auf, wodurch die einzelnen elektrischen Funktionseinheiten in Richtung des Gehäusedeckels durch die deckelseitigen Hochfrequenzkammern voneinander getrennt sind.

Besonders vorteilhaft ist hierbei, dass eine gemeinsame Leiterplatte mehrere elektrische Funktionseinheiten aufweist, die durch die Anordnung der oberseitigen und unterseitigen Massebereiche voneinander getrennt werden. Weiterhin ist vorteilhaft, dass es bodenseitige Abstütztrennwände gibt, auf denen die Leiterplatte als Ganzes abgestützt ist. Auf den Einsatz von isolierenden Zwischenschichten kann verzichtet werden, weil die bodenseitigen Abstütztrennwände auf den unterseitigen Massebereichen bzw. auf Bereichen aufliegen, an denen keine Leiterstruktur ausgebildet ist. Besonders vorteilhaft ist außerdem, dass die bodenseitigen Abstütztrennwände zwei Funktionen gleichzeitig erfüllen. Sie dienen einerseits dazu, die Leiterplatte zu tragen und bilden andererseits verschiedene bodenseitige Hochfrequenzkammern. Elektrische Bauteile der einzelnen Funktionseinheiten stehen von der Leiterplatte ab und sind in diesen bodenseitigen Hochfrequenzkammern bzw. in den dazu korrespondierenden deckelseitigen Hochfrequenzkammern angeordnet. Die von diesen Bauteilen emittierte Strahlung kann die Funktionsweise der anderen elektrischen Funktionseinheiten nicht mehr beeinflussen. Der Zusammenbau des Hochfrequenzverstärkers ist dabei sehr einfach gehalten. Die Leiterplatte wird auf den Gehäuseboden gelegt, wobei im nächsten Schritt der Zwischendeckel auf der Leiterplatte angeordnet wird. Es müssen weder unterschiedliche Leiterplatten eingesetzt und angeschlossen werden, noch müssen zusätzliche unterschiedliche Trennwände eingesetzt werden. Es ist außerdem anzumerken, dass die einzelnen deckelseitigen Hochfrequenzkammern in Draufsicht betrachtet deckungsgleich zu den bodenseitigen Hochfrequenzkammern angeordnet sind. Die Störstrahlung einer elektrischen Funktionseinheit wird sowohl von der Oberseite der Leiterplatte nach oben, als auch durch die Leiterplatte durch nach unten emittiert. Die Störstrahlung wird daher sowohl in die deckelseitige Hochfrequenzkammer, als auch in die darunter liegende bodenseitige Hochfrequenzkammer emittiert. Eine Ausnahme könnte allerdings dann bestehen, wenn eine durchgängige Zwischenlage aus Metall im Bereich unter bzw. über der jeweiligen Hochfrequenzkammer, in welche die elektrische Funktionseinheit angeordnet ist, in der Leiterplatte ausgebildet wäre.

Um das Durchbiegen der Leiterplatte zu vermeiden, sind die deckelseitigen Abstützwände und die bodenseitigen Abstützwände überwiegend oder vollständig übereinander angeordnet. Dies bedeutet, dass sie in Draufsicht ganz oder teilweise überlappend oder deckungsgleich zueinander angeordnet sind.

In diesem Fall ist es vorzugsweise ebenfalls so, dass die oberseitigen Massebereiche, auf denen die deckelseitigen Abstütztrennwände anliegen und die unterseitigen Massebereiche, die auf den bodenseitigen Abstütztrennwänden aufliegen, überwiegend oder vollständig übereinander angeordnet sind.

In einer erfindungsgemäßen Weiterbildung umfasst der Hochfrequenzverstärker eine Vielzahl von Durchkontaktierungen, die die oberseitigen Massebereiche mit den unterseitigen Massebereichen der Leiterplatte galvanisch verbinden. Dadurch wird eine Kopplung der einzelnen elektrischen Funktionseinheiten untereinander, die parallel zur Leiterplatte innerhalb dieser erfolgt, vermieden.

In einer zusätzlichen Weiterbildung des erfindungsgemäßen Hochfrequenzverstärkers durchsetzen mehrere Schraubverbindungen den Zwischendeckel und die Leiterplatte und enden im Gehäuseboden, wodurch der Zwischendeckel mit seinen deckelseitigen Abstütztrennwänden auf die Leiterplatte gedrückt bzw. gepresst ist und wobei die Leiterplatte auf die bodenseitigen Abstütztrennwände gedrückt bzw. gepresst ist. Dadurch kann ein sehr kompakter "Sandwich"-Aufbau aus Zwischendeckel, Leiterplatte und Gehäuseboden realisiert werden.

Eine andere Weiterbildung des erfindungsgemäßen Hochfrequenzverstärkers zeigt einen Zwischendeckel, der zumindest eine in Richtung des Gehäusedeckels zeigende Öffnung aufweist, durch die sich zumindest ein Bauteil bzw. eine Steckkarte, das bzw. die auf der Leiterplatte angeordnet ist, hindurch erstreckt und vorzugsweise gegen ein Verkippen geschützt ist. Je nach Art der Steckkarten können diese einfach eingesteckt werden, ohne dass der Zwischendeckel entfernt werden muss. Dadurch, dass die Öffnungen in Richtung des Gehäusedeckels zeigen und eine nur geringe Öffnungsbreite bzw. Öffnungslänge aufweisen, beeinflussen sich die einzelnen deckelseitigen Hochfrequenzkammern, in die die Öffnungen münden, nicht gegenseitig. Ein Schutz gegen Verkippen ist insbesondere dann wünschenswert, wenn der Hochfrequenzverstärker zum Einsatzort transportiert wird. Vibrationen könnten sonst dazu führen, dass sich die Bauteile lösen.

In einer anderen Weiterbildung des Hochfrequenzverstärkers ist der Zwischendeckel ausschließlich in dem Aufnahmeraum angeordnet. Ergänzend oder alternativ kann dies auch für die Leiterplatte gelten. Dies bedeutet, dass weder der Zwischendeckel noch die Leiterplatte einen Teil der Außenumfangswandung der umlaufenden Gehäusewand bilden. Der Zwischendeckel und die Leiterplatte sind nach Schließen des Gehäusedeckels auch vor Witterungseinflüssen geschützt. Feuchtigkeit bzw. Bodenfrost können den Zwischendeckel und der Leiterplatte nichts mehr anhaben.

In einer zusätzlichen Weiterbildung des erfindungsgemäßen Hochfrequenzverstärkers sind die deckelseitigen Abstütztrennwände (bezogen auf die Leiterplatte) höher als die bodenseitigen Abstütztrennwände, wodurch das Volumen der deckelseitigen Hochfrequenzkammern größer ist als das der jeweils unter diesen angeordneten bodenseitigen Hochfrequenzkammern. Unter dem Wortlaut "höher" wird die Erstreckung in Axialrichtung, also vom Gehäuseboden in Richtung des Gehäusedeckels oder umgekehrt verstanden. Die deckelseitigen Abstütztrennwände sind vorzugsweise mehr als 1,5 Mal, weiter vorzugsweise mehr als 2 Mal, weiter vorzugsweise mehr als 3 Mal, weiter vorzugsweise mehr als 4 Mal so hoch, wie die bodenseitigen Abstütztrennwände. Dies gilt insbesondere dann, wenn die überwiegende Anzahl der Bauteile auf der Oberseite der Leiterplatte angeordnet sind. Falls die überwiegende Anzahl der Bauteile auf der Unterseite der Leiterplatte angeordnet sind, dann wären vorzugsweise die bodenseitigen Abstütztrennwände höher als die deckelseitigen Abstütztrennwände. Beide Abstütztrennwände könnten auch gleich hoch sein.

Ein weiteres Ausführungsbeispiel des Hochfrequenzverstärkers sieht vor, dass zumindest einige der elektrischen Funktionseinheiten, die in unterschiedlichen deckel- und/oder bodenseitigen Hochfrequenzkammern angeordnet sind, auf der Oberseite der Leiterplatte miteinander an zumindest einem oberseitigen Kontaktbereich elektrisch verbunden sind. Dieser oberseitige Kontaktbereich wird dabei vorzugsweise als der Bereich verstanden, an dem die elektrischen Leiterbahnen von der einen Funktionseinheit zur anderen Funktionseinheit übergehen.

An diesem zumindest einen oberseitigen Kontaktbereich weisen die oberseitigen Massebereiche hierfür eine Unterbrechung auf. An diesem zumindest einen oberseitigen Kontaktbereich weisen außerdem die deckelseitigen Abstütztrennwände eine Ausnehmung auf und sind von der Oberseite der Leiterplatte beabstandet. Im Gegensatz dazu liegen vorzugsweise alle bodenseitigen Abstütztrennwände der bodenseitigen Hochfrequenzkammern unterbrechungsfrei auf der Unterseite der Leiterplatte an. Dadurch wird erreicht, dass die einzelnen Funktionseinheiten elektrische Signale bzw. Daten miteinander austauschen können. Die Leiterplatte kann dabei zweilagig ausgeführt sein, wobei die einzelnen Funktionseinheiten insbesondere über ihre Oberseite die Daten bzw. elektrischen Signale miteinander austauschen. Weil es sich hierbei oft um analoge Signale handelt, würde ein solches Signal in seiner Qualität verschlechtert werden, wenn es von der Oberseite der Leiterplatte, also von der oberen Lage in eine Zwischenlage der Leiterplatte geleitet werden würde. Die Ausnehmungen in dem oberseitigen Massebereich und in den deckelseitigen Abstütztrennwänden sind gerade so klein, dass der Daten- bzw. Signalaustausch erfolgen kann (ausreichend groß für die Leiterbahn), wobei die elektrische Störstrahlung, die von den einzelnen Funktionseinheiten ausgehen kann, nicht über die Luft übertragen werden kann.

Es wäre natürlich auch möglich, dass die Übertragung der Daten bzw. Signale zwischen den einzelnen elektrischen Funktionseinheiten auf einer Unterseite der Leiterplatte erfolgt. Die genannten Ausführungen wären dann jeweils auf der anderen Seite der Leiterplatte anzutreffen. Die Datenübertragung zwischen den einzelnen elektrischen Funktionseinheiten erfolgt vorzugsweise entweder nur auf der Oberseite oder nur auf der Unterseite der Leiterplatte.

In diesem Zusammenhang zeigt eine Weiterbildung des Hochfrequenzverstärkers, dass eine Steuereinheit auf der Leiterplatte angeordnet ist und von einer deckel- und bodenseitigen Hochfrequenzkammer eingeschlossen ist, wobei diese im Zentrum der anderen deckel- und bodenseitigen Hochfrequenzkammern liegt. Eine solche Steuereinheit, bei welcher es sich ebenfalls um eine elektrische Funktionseinheit handelt, kommuniziert mit den meisten oder allen anderen elektrischen Funktionseinheiten. Dadurch, dass diese im Zentrum der Leiterplatte angeordnet ist, können kurze Wege zur Signalübertragung erreicht werden. Die Steuereinheit kann die notwendigen Steuersignale direkt an die jeweiligen Funktionseinheiten übermitteln. Die Steuersignale müssen nicht noch zusätzlich den Weg durch andere Funktionseinheiten und damit durch andere deckel- und bodenseitige Hochfrequenzkammern zurücklegen.

In einer Weiterbildung des Hochfrequenzverstärkers weist dieser zumindest einen bodenseitigen Kühlkörper auf, der sich in axialer Richtung vom Gehäuseboden in Richtung des Gehäusedeckels erstreckt. Der zumindest eine bodenseitige Kühlkörper ist einteilig mit dem Gehäuseboden ausgebildet. Zumindest eine untere Wärmequelle ist an der Unterseite der Leiterplatte angeordnet. Der zumindest eine bodenseitige Kühlkörper liegt direkt an der zumindest einen unteren Wärmequelle an und/oder ist von der zumindest einen unteren Wärmequelle durch einen Spalt beabstandet. In diesem Spalt ist ein Wärmeleitmittel (z.B. Wärmeleitpaste) eingebracht, um die von der zumindest einen unteren Wärmequelle erzeugten Wärme an den zumindest einen bodenseitigen Kühlkörper zu übertragen.

Besonders vorteilhaft ist es hier, dass der bodenseitige Kühlkörper einteilig mit dem Gehäuseboden ausgebildet ist. Dadurch ist ein Wärmeübergangswiderstand zwischen dem Gehäuseboden und dem bodenseitigen Kühlkörper sehr gering. Die Wärmespreizung im Gehäuseboden ist sehr ausgeprägt. Unter einer unteren Wärmequelle kann beispielswese ein auf der Unterseite der Leiterplatte befindliches Bauteil (Transistor, IGBT, Mikrokontroller, FPGA, usw.) verstanden werden. Unter einer Wärmequelle kann allerdings auch ein Inlay, also ein Hitzeverteiler (engl. Heatspreader) verstanden werden, das die Wärme von einem auf der gegenüberliegenden Seite der Leiterplatte angeordneten Bauelements nach unten, also in Richtung der Unterseite der Leiterplatte abführt.

Es wäre natürlich auch möglich, dass anstelle oder in Ergänzung zu einem bodenseitigen Kühlkörper ein deckelseitiger Kühlkörper eingesetzt wird. Die vorstehend gemachten Ausführungen gelten ebenfalls für einen solchen deckelseitigen Kühlkörper. In diesem Fall wären der deckelseitige Kühlkörper und der bodenseitige Kühlkörper vorzugsweise überwiegend oder vollständig übereinander angeordnet, damit Druck- bzw. Zugkräfte, die von einem Kühlkörper ausgehen, direkt von dem anderen Kühlkörper aufgenommen werden können, wodurch eine Biegung der Leiterplatte vermieden wird.

Eine Weiterbildung des Hochfrequenzverstärkers sieht vor, dass die umlaufende Gehäusewand mehrere Anschlussöffnungen zum Anschluss von Koaxialkabeln und/oder Glasfaserkabeln aufweist, wobei in zumindest eine deckel- und/oder bodenseitige Hochfrequenzkammer zwei Anschlussöffnungen münden, die in einem Winkel von in etwa 90° zueinander stehen. Dadurch kann erst zum Zeitpunkt der Installation die jeweilige Anschlussöffnung ausgewählt werden, die günstiger liegt. Je nachdem, in welcher Lage der Hochfrequenzverstärker eingesetzt werden soll, ist ein Anfahren der entsprechenden Hochfrequenzkammer mit dem Anschlusskabel sehr leicht möglich. Die Anschlussöffnungen, die nicht verwendet werden, werden mit einem Deckel, der vorzugsweise ein Gewinde umfasst, versiegelt. Dadurch wird das Eindringen von Feuchtigkeit oder Wasser vermieden.

In einer zusätzlichen Weiterbildung des Hochfrequenzverstärkers belegen der Zwischendeckel, die Leiterplatte und der Teil des Gehäusebodens, an dem die bodenseitigen Hochfrequenzkammern ausgebildet sind, nur einen Teil des Aufnahmeraums des Hochfrequenzverstärkers. Dies erlaubt, dass ein Netzteil in den anderen Teil des Aufnahmeraums angeordnet und somit direkt auf dem Gehäuseboden aufliegen kann. Dies erlaubt, dass das Netzteil zum einen ungeschirmt ist, wobei etwaige Schaltimpulse des Netzteils die elektrischen Funktionseinheiten aufgrund ihrer Schirmung durch den Zwischendeckel und die Massebereiche auf der Leiterplatte und die dadurch entstehenden deckel- bzw. bodenseitigen Hochfrequenzkammern nicht stören und zum anderen eine Wärmeabfuhr unmittelbar an dem Gehäuseboden möglich ist.

Schlussendlich wird in einer anderen Weiterbildung des Hochfrequenzverstärkers gezeigt, dass der Gehäuseboden zusammen mit der umlaufenden Gehäusewand in einem Druckgussverfahren und/oder Fräsverfahren einteilig hergestellt werden kann. Das Gleiche gilt auch für den Zwischendeckel. In diesem Fall können die Abstütztrennwände, die im Stand der Technik aufwändig von Hand eingesetzt werden müssen, direkt im Herstellungsprozess mitgeschaffen werden. Die gesamte Anordnung ist in diesem Fall auch deutlich stabiler und hält Erschütterungen beim Transport zum Einsatzort viel besser Stand.

Verschiedene Ausführungsbeispiele der Erfindung werden nachfolgend unter Bezugnahme auf die Zeichnungen beispielhaft beschrieben. Gleiche Gegenstände weisen dieselben Bezugszeichen auf. Die entsprechenden Figuren der Zeichnungen zeigen im Einzelnen:
- Figur 1:: eine Draufsicht auf den erfindungsgemäßen Hochfrequenzverstärker;
- Figur 2:: eine Explosivdarstellung des erfindungsgemäßen Hochfrequenzverstärkers;
- Figur 3:: eine Draufsicht auf den Gehäuseboden des Hochfrequenzverstärkers;
- Figur 4:: verschiedene unterseitige Massebereiche einer Leiterplatte, die die Anordnung der einzelnen bodenseitigen Hochfrequenzkammern beschreiben, wobei verschiedene elektrische Funktionseinheiten zwischen den unterseitigen Massebereichen angeordnet sind;
- Figur 5:: eine Draufsicht auf eine Unterseite eines Zwischendeckels, wobei die einzelnen deckelseitigen Hochfrequenzkammern zu erkennen sind;
- Figur 6:: verschiedene oberseitige Massebereiche einer Leiterplatte, die die Anordnung der einzelnen deckelseitigen Hochfrequenzkammern beschreiben, wobei verschiedene elektrische Funktionseinheiten zwischen den oberseitigen Massebereichen angeordnet sind;
- Figur 7:: einen Längsschnitt durch den erfindungsgemäßen Hochfrequenzverstärker; und
- Figur 8:: eine vergrößerte Darstellung eines Teils des Längsschnitts aus Figur 7 durch den erfindungsgemäßen Hochfrequenzverstärker.

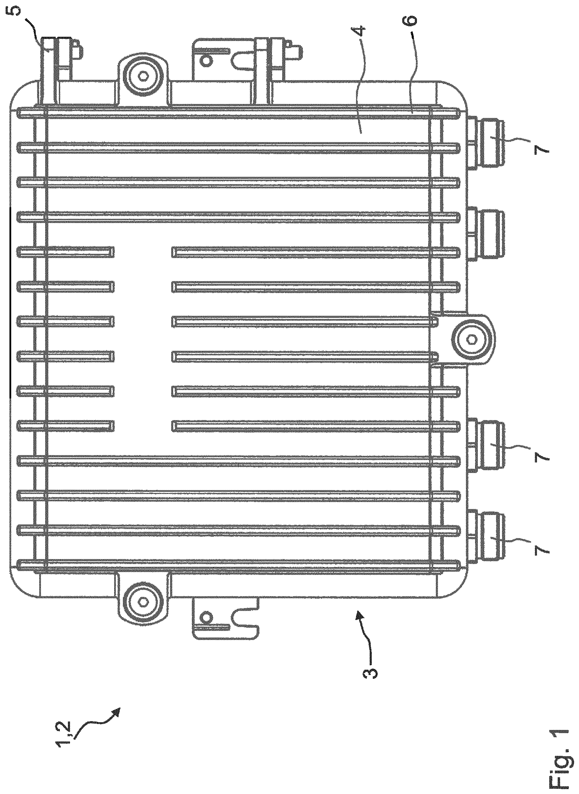

Figur 1 zeigt eine Draufsicht auf den erfindungsgemäßen Hochfrequenzverstärker 1, der ein Hochfrequenzgehäuse 2 aufweist, das einen Gehäusekörper 3 und einen Gehäusedeckel 4 umfasst. Über Scharniere 5 kann der Gehäusedeckel 4 aufgeklappt und zugeklappt werden. Der Gehäusedeckel 4 ist mit deckelseitigen Kühlrippen 6 versehen, um die im Inneren des Gehäusekörpers 3 entstehende Wärme abzuführen. Anschlusskontakte 7 dienen zum Anschluss des Hochfrequenzverstärkers 1 an ein Koaxialnetzwerk. Über die Anschlusskontakte 7 können auch Glasfaserkabel und Stromkabel dem Hochfrequenzverstärker 1 zugeführt werden.

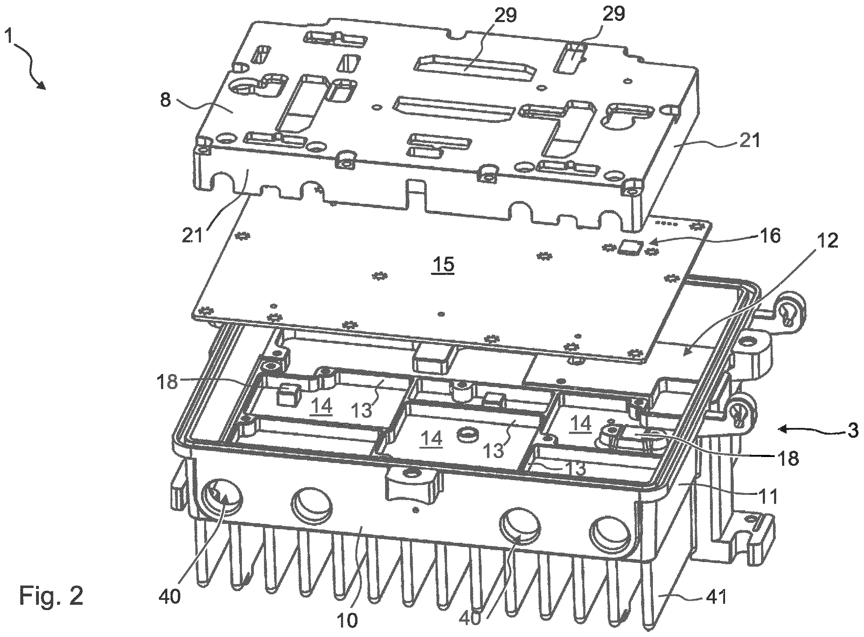

Figur 2 zeigt den Hochfrequenzverstärker 1 aus Figur 1 in Explosivdarstellung. Nicht dargestellt ist der Gehäusedeckel 4. Der Gehäusekörper 3 weist einen Gehäuseboden 10 und eine zwischen den Gehäuseboden 10 und dem Gehäusedeckel 4 umlaufende Gehäusewand 11 auf, wodurch ein Aufnahmeraum 12 gebildet ist und wodurch der Gehäusedeckel 4 von dem Gehäuseboden 10 des Gehäusekörpers 3 beabstandet ist.

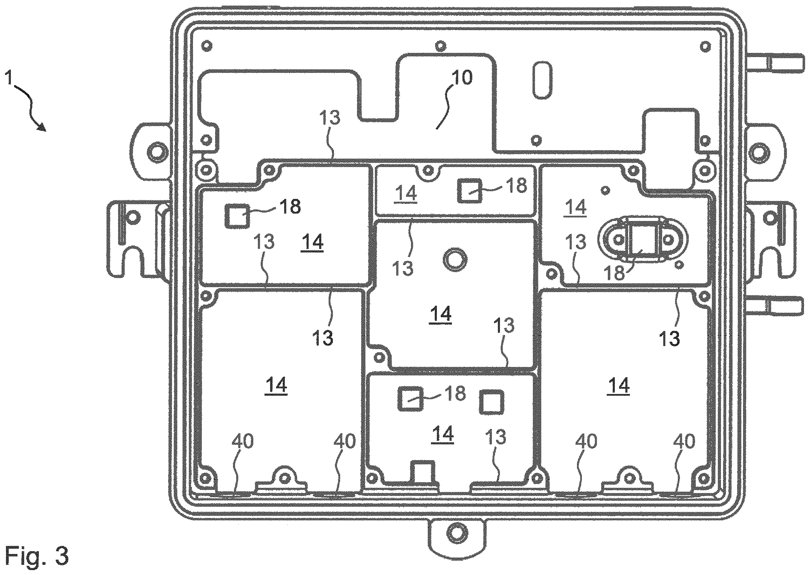

Der Gehäusekörper 3 umfasst außerdem eine Vielzahl von bodenseitigen Abstützelementen 13, die in Figur 3, die eine Draufsicht auf den Gehäuseboden 10 zeigt, vergrößert dargestellt sind. Die bodenseitigen Abstütztrennwände 13 sind galvanisch mit dem Gehäuseboden 10 verbunden und einteilig mit diesem ausgebildet. Die Vielzahl von bodenseitigen Abstütztrennwänden 13 erstrecken sich in axialer Richtung vom Gehäuseboden 10 in Richtung des Gehäusedeckels 4, wodurch mehrere bodenseitige Hochfrequenzkammern 14 gebildet sind.

Mit Hinblick auf die Figuren 2 und 3 ist zu erkennen, dass die bodenseitigen Hochfrequenzkammern 14 voneinander isoliert sind. In den bodenseitigen Abstützwänden 13 gibt es keine Unterbrechungen, durch die elektromagnetische Strahlung von einer bodenseitigen Hochfrequenzkammer 14 in eine benachbarte bodenseitige Hochfrequenzkammer 14 einkoppeln könnte.

Der Hochfrequenzverstärker 1 umfasst außerdem eine Leiterplatte 15, die mehrere elektrische Funktionseinheiten 16 aufweist. Die einzelnen elektrischen Funktionseinheiten 16 können Bauelemente umfassen, die sich im Betrieb erwärmen und gekühlt werden müssen. Eine passive Kühlung ist hier meistens ausreichend.

Figur 3 zeigt hierfür, dass sich zumindest ein bodenseitiger Kühlkörper 18 in axialer Richtung vom Gehäuseboden 10 in Richtung des Gehäusedeckels 4 erstreckt. Der zumindest eine bodenseitige Kühlkörper 18 ist einteilig mit dem Gehäuseboden 10 ausgebildet. Dieser zumindest eine bodenseitige Kühlkörper 18 könnte direkt an zumindest einer unteren Wärmequelle anliegen, die auf der Unterseite 25 der Leiterplatte 15 angeordnet ist. In diesem Fall ist der zumindest eine bodenseitige Kühlkörper 18 allerdings von der zumindest einen unteren Wärmequelle durch einen Spalt beabstandet, wobei in diesem Spalt ein Wärmeleitmittel 20 eingebracht ist, um die von der zumindest einen unteren Wärmequelle erzeugte Wärme an den zumindest einen bodenseitigen Kühlkörper 18 zu übertragen.

Bei den elektrischen Funktionseinheiten kann es sich beispielsweise um einen Vorverstärker und/oder um eine Zwischenstufe und/oder um eine Endstufe und/oder um eine Mittelstufenkammer und/oder um eine Ausgangskammer und/oder um eine Steuerkammer handeln. Der Hochfrequenzverstärker 1 arbeitet vorzugsweise im Frequenzbereich von 5 MHz bis 1,2 GHz und eignet sich zur Übertragung von TV-, Internet- und Telefonie-Daten.

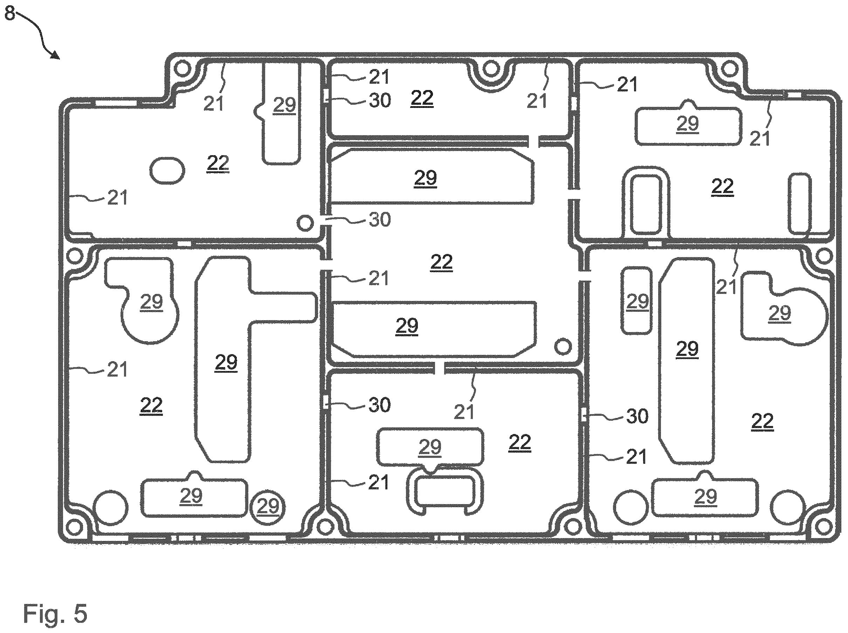

Figur 2 zeigt ebenfalls den Einsatz eines Zwischendeckels 8, der mit Hinblick auf Figur 5 eine Vielzahl von deckelseitigen Abstütztrennwänden 21 aufweist, die galvanisch mit dem Zwischendeckel 8 verbunden und einteilig mit diesem ausgebildet sind. Die Vielzahl der deckelseitigen Abstütztrennwände 21 erstrecken sich in axialer Richtung von dem Zwischendeckel 8 in Richtung des Gehäusebodens 10, wodurch mehrere deckelseitige Hochfrequenzkammern 22 gebildet sind.

Erfindungsgemäß wird die Leiterplatte 15 auf die bodenseitigen Abstütztrennwände 13 aufgelegt. Im Weiteren wird der Zwischendeckel 8 mit den deckelseitigen Abstütztrennwänden 22 auf die Leiterplatte 15 aufgelegt, wodurch eine "Sandwich"-Konstruktion entsteht. Die Leiterplatte ist durchgehend und überdeckt vorzugsweise alle elektrischen Funktionseinheiten 16. Die Leiterplatte umfasst dazu zumindest so viele elektrische Funktionseinheiten 16, wie es bodenseitige Hochfrequenzkammern 14 bzw. deckelseitige Hochfrequenzkammern 22 gibt. Vorzugsweise liegt eine elektrische Funktionseinheit in einer der Hochfrequenzkammern 14, 22 an, wobei eine Hochfrequenzkammer aus einer Bodenseitigen Hochfrequenzkammer 14 und einer deckelseitigen Hochfrequenzkammer 22 gebildet ist.

Die deckelseitigen Abstütztrennwände 21, wie sie beispielsweise in Figur 5 zu sehen sind und die Bodenseitigen Abstützelemente 13, wie sie beispielsweise in Figur 3 zu sehen sind, sind überwiegend oder vollständig übereinander angeordnet, wodurch das Durchbiegen der Leiterplatte 15 reduziert oder unterbunden ist. Sie sind sozusagen zur Leiterplatte 15 symmetrisch angeordnet. Dies bedeutet, dass sie in Draufsicht ganz oder teilweise überlappend oder vorzugsweise deckungsgleich angeordnet sind.

Über mehrere nicht dargestellte Schraubverbindungen, die den Zwischendeckel 8 und die Leiterplatte 15 durchsetzen und im Gehäuseboden 10 enden, wird bei Anziehen dieser Schraubverbindungen der Zwischendeckel 8 mit seinen deckelseitigen Abstütztrennwänden 21 fest auf die Leiterplatte 15 gedrückt. Die Leiterplatte 15 wird wiederum fest auf die bodenseitigen Abstütztrennwände 13 gedrückt. Dadurch wird jede elektrische Funktionseinheit 16 von einer deckelseitigen Hochfrequenzkammer 22 und der dazu korrespondierenden bodenseitigen Hochfrequenzkammer 14 eingeschlossen. Die zueinander korrespondierenden Hochfrequenzkammern 14, 22 haben in der Fläche vorzugsweise in etwa die gleichen Abmessungen können sich aber in ihrem Volumen voneinander unterscheiden.

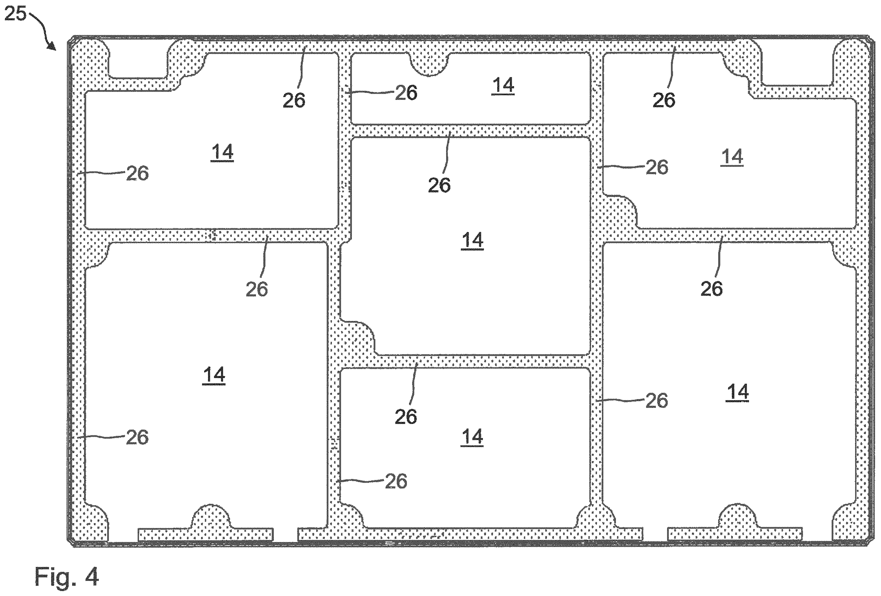

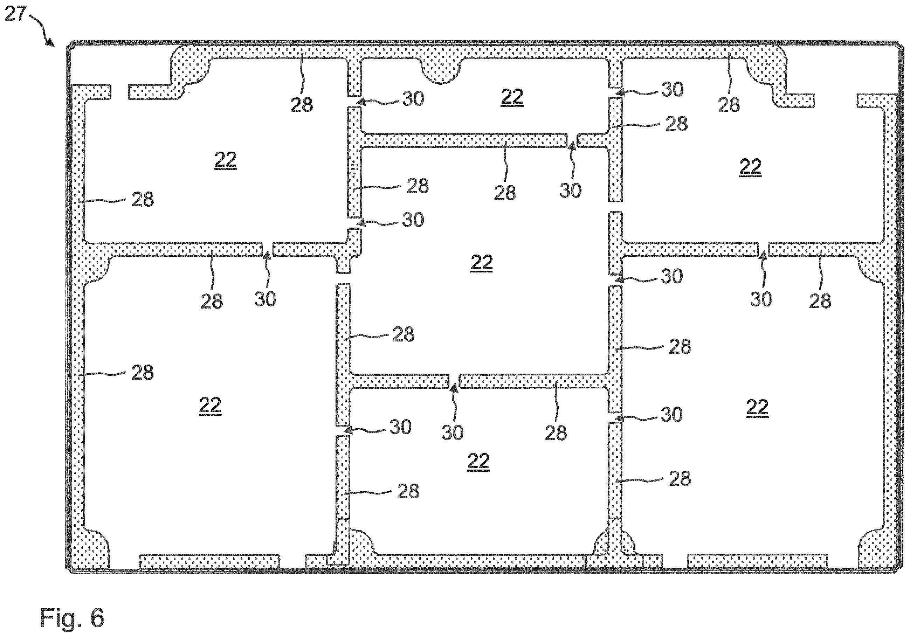

Mit Hinblick auf Figur 4 ist eine Unterseite 25 der Leiterplatte 15 zu sehen. Gepunktet dargestellt sind unterseitige Massebereiche 26, die die einzelnen elektrischen Funktionseinheiten 16 voneinander zu trennen. Im Gegensatz dazu zeigt Figur 6 eine Oberseite 27 der Leiterplatte 15. Die oberseitigen Massebereiche 28 sind ebenfalls gepunktet dargestellt und dienen dazu, die elektrischen Funktionseinheiten 16 voneinander zu trennen. Die Oberseite 27 der Leiterplatte 15 ist in Richtung des Zwischendeckels 8 gerichtet, wohingegen die Unterseite 25 der Leiterplatte 15 in Richtung des Gehäusebodens 10 gerichtet ist.

Vorzugsweise sind die oberseitigen Massebereiche 28 und die unterseitigen Massebereiche 26 überwiegend oder vollständig übereinander angeordnet, also in Draufsicht ganz oder teilweise überlappend oder deckungsgleich zueinander angeordnet.

Auf den oberseitigen Massebereichen 28 liegen vorzugsweise die deckelseitigen Abstütztrennwände 21 an. Die deckelseitigen Abstütztrennwände 21 liegen vorzugweise einzig auf den oberseitigen Massebereichen 28 an. Gleiches gilt für die unterseitigen Massebereiche 26. Diese liegen vorzugsweise einzig auf den bodenseitigen Abstütztrennwänden 13 auf. Dies bedeutet, dass vorzugsweise die bodenseitigen Abstütztrennwände 13 einzig die Leiterplatte 15 an den unterseitigen Massebereichen 26 berühren. Es liegt daher eine galvanische Verbindung zwischen den deckelseitigen Abstütztrennwänden 21 und den oberseitigen Massebereichen 28 vor. Gleiches gilt ebenfalls für die bodenseitigen Abstütztrennwände 13 und die unterseitigen Massebereiche 26.

Die Leiterplatte 15 liegt mit ihrem unterseitigen Umfangsbereich 25, wie er in Figur 4 zu sehen ist, überwiegend oder voll umfänglich auf dem bodenseitigen Abstütztrennwänden 13 und/oder auf einer Auflageschulter des Gehäusebodens 10 auf. Der unterseitige Umfangsbereich ist durch diejenigen unterseitigen Massebereiche 26 gekennzeichnet, die am Rand der Leiterplatte 15 angeordnet sind. Darunter sind insbesondere diejenigen unterseitigen Massebereiche zu verstehen, die vom Rand der Leiterplatte 15 weniger als 1 cm, vorzugsweise weniger als 0,5 cm beabstandet sind.

In analoger Weise dazu liegt der Zwischendeckel 8 mit seinen deckelseitigen Abstützwänden 21 überwiegend oder voll umfänglich auf einem oberseitigen Umfangsbereich der Leiterplatte 15 auf, wie er in Figur 6 dargestellt ist. Bei diesem oberseitigen Umfangsbereich handelt es sich ebenfalls um den Bereich der oberseitigen Massebereiche 28, die am Rand der Leiterplatte 15 angeordnet sind.

Eine etwaige Störstrahlung kann nur noch über die Leiterplatte 15 übertragen werden, die alle Hochfrequenzkammern 14, 22 gleichermaßen bedeckt. Um dem entgegenzuwirken sind die oberseitigen Massebereiche 28 mit den unterseitigen Massebereichen 26 über eine Vielzahl von Durchkontaktierungen galvanisch verbunden.

Mit Hinblick auf Figur 4 sind alle unterseitigen Massebereiche 26 galvanisch über die gleiche Seite 25, also die gleiche Lage der Leiterplatte 15 miteinander verbunden. In diesem Fall sind die unterseitigen Massebereiche 26 über die Unterseite 25 der Leiterplatte 15 miteinander verbunden. Eine solche Verbindung erfolgt ohne den Einsatz von Durchkontaktierungen.

Gleiches kann auch für die oberseitigen Massebereiche 28 gelten. Innerhalb von Figur 6 sind allerdings nicht alle oberseitigen Massebereiche 28 galvanisch über die gleiche Seite 27, also die gleiche Lage der Leiterplatte 15 miteinander verbunden. Die überwiegende Anzahl der oberseitigen Massebereiche 28 ist allerdings über die Oberseite 27 der Leiterplatte 15 miteinander verbunden.

Innerhalb von Figur 6 sind diejenigen Bereiche zu erkennen, die zu den deckelseitigen Hochfrequenzkammern 22 gehören. In diesen Bereichen sind die elektrischen Funktionseinheiten 16 angeordnet. Dabei spielt es keine Rolle, ob die elektrischen Funktionseinheiten auf der Oberseite 27 und/oder auf der Unterseite 25 der Leiterplatte 15 angeordnet sind. In dem Ausführungsbeispiel des Hochfrequenzverstärkers 1 ist für Bauteile, die zu den elektrischen Funktionseinheiten 16 gehören, allerdings auf der Oberseite 27 der Leiterplatte 15 mehr Platz.

In Figur 6 ist gezeigt, dass zumindest einige der elektrischen Funktionseinheiten 16 an zumindest einem oberseitigen Kontaktbereich elektrisch miteinander verbunden sind. Auf die Darstellung der Leiterbahnen wurde in dieser Zeichnungsfigur verzichtet. An diesem zumindest einen oberseitigen Kontaktbereich weisen daher die oberseitigen Massebereiche 28 eine Unterbrechung 30 auf. Mit Hinblick auf Figur 5 ist zu erkennen, dass an diesen Kontaktbereichen die deckelseitigen Abstützwände 21 ebenfalls eine Ausnehmung 30 aufweisen. An diesen Kontaktbereichen sind die deckelseitigen Abstütztrennwände 21 daher von der Oberseite 27 der Leiterplatte 15 beabstandet. Im Gegensatz dazu weisen vorzugsweise alle bodenseitigen Abstütztrennwände 13 der bodenseitigen Hochfrequenzkammern 14 keine Unterbrechungen auf und liegen durchgehend auf der Unterseite 25 der Leiterplatte 15 an. Die Unterbrechungen 30 in dem oberseitigen Massebereich 28 bzw. in den deckelseitigen Abstütztrennwänden 21 sind von ihrer Größe her so klein dimensioniert, dass bezogen auf die höchste Betriebsfrequenz in den jeweiligen elektrischen Funktionseinheiten 16 eine hochfrequente Isolation zwischen den einzelnen Hochfrequenzkammern 14, 22 erhalten bleibt. Dies bedeutet, dass die Größe der Unterbrechungen 30 unterschiedlich sein kann.

Es wäre hier auch möglich, dass die Unterbrechungen in den unterseitigen Massebereichen 26 und in den bodenseitigen Abstütztrennwänden 13 ausgebildet wären. Vorzugsweise ist eine Steuereinheit im Zentrum auf der Leiterplatte 15 angeordnet. Dadurch kann die Steuereinheit mit möglichst kurzen Leitungslängen mit allen anderen elektrischen Funktionseinheiten 16 verbunden werden.

Mit Hinblick auf Figur 2 sind außerdem noch mehrere Anschlussöffnungen 40 zu erkennen, die zum Anschluss von Koaxialkabeln und/oder Glasfaserkabeln und/oder Stromkabeln dienen. Diese sind in die umlaufende Gehäusewand 11 eingebracht und münden in zumindest einer deckelseitigen und/oder bodenseitigen Hochfrequenzkammer 14, 22. Glasfaserkabel werden vorzugsweise durch die Anschlussöffnungen 40 hindurchgeführt, wobei die restliche Öffnung durch ein Verschlusselement verschlossen wird. Gleiches gilt auch für nicht benötigte Anschlussöffnungen 40. Vorzugsweise weisen diejenigen Hochfrequenzkammern 14, 22, die zur Aufnahme von Koaxialkabeln und/oder Glasfaserkabeln bestimmt sind, zwei Anschlussöffnungen 40 auf, die in einem Winkel von etwa 90° zueinander stehen und in die jeweilige Hochfrequenzkammer 14, 22 münden. Dadurch ist gewährleistet, dass unabhängig von der Ausrichtung des Hochfrequenzverstärkers 1 am Installationsort das Koaxialkabel und/oder das Glasfaserkabel angeschlossen werden kann.

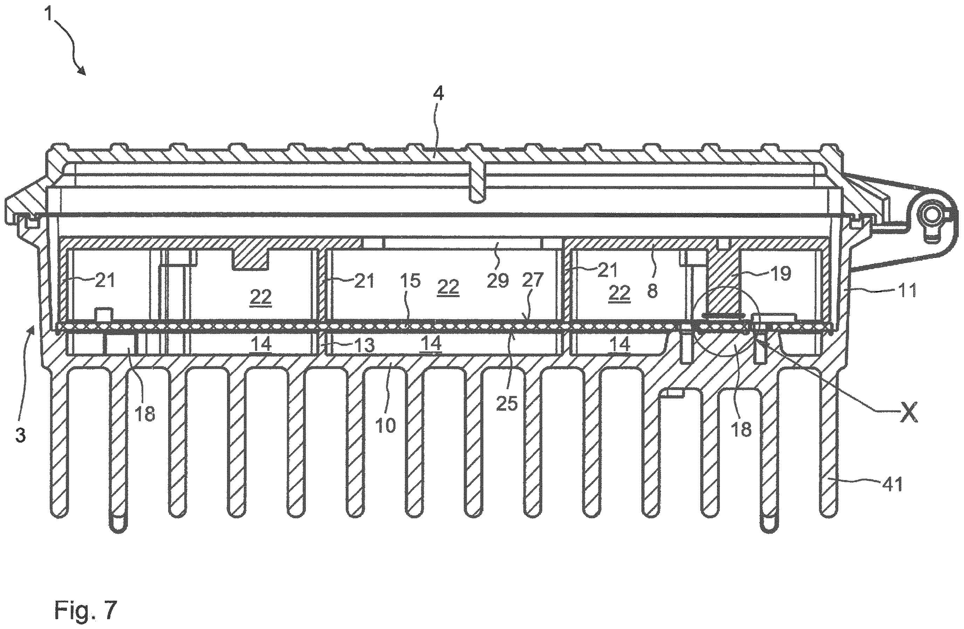

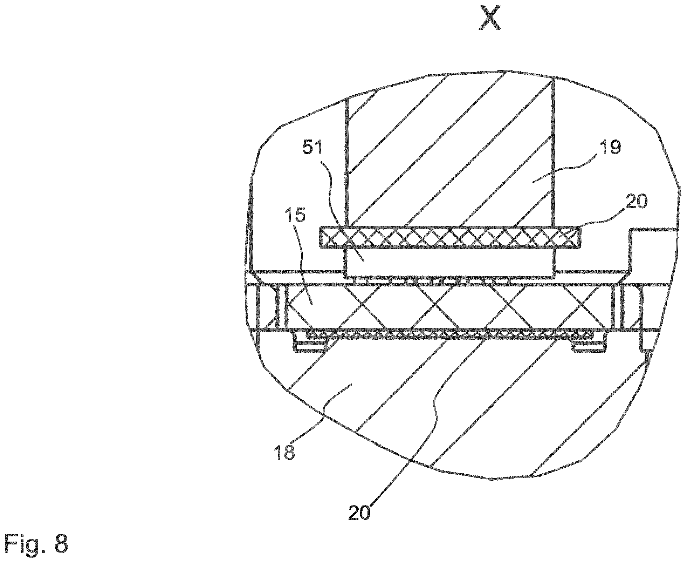

Figur 7 zeigt einen Längsschnitt durch den erfindungsgemäßen Hochfrequenzverstärker 1, wobei Figur 8 eine vergrößerte Darstellung eines Bereichs des Längsschnitts aus Figur 7 wiedergibt. Die deckelseitigen Abstütztrennwände 21 sind bezogen auf die Leiterplatte 15 höher als die bodenseitigen Abstütztrennwände 13, wodurch das Volumen der deckelseitigen Hochfrequenzkammern 22 größer ist, als das der jeweiligen in Richtung des Gehäusebodens 10 beabstandeten bodenseitigen Hochfrequenzkammern 14.

Dargestellt ist außerdem, dass der Zwischendeckel 8 ausschließlich in dem Aufnahmeraum 12 angeordnet ist. Gleiches gilt für die Leiterplatte 15. Es wird nur eine Leiterplatte 15 verwendet, auf der alle elektrischen Funktionseinheiten 16 angeordnet sind.

Der deckelseitige Kühlkörper 19 erstreckt sich in axialer Richtung vom Zwischendeckel 8 in Richtung des Gehäusebodens 10. Der zumindest eine deckelseitige Kühlkörper 19 ist ebenfalls einteilig mit dem Zwischendeckel 8 ausgebildet. Dargestellt ist außerdem eine obere Wärmequelle 51, die an der Oberseite 27 der Leiterplatte 15 angeordnet ist. Der zumindest eine deckelseitige Kühlkörper 19 ist von der zumindest einen oberen Wärmequelle 51 durch einen Spalt beabstandet, wobei in diesem Spalt ein Wärmeleitmittel 20 eingebracht ist, um die von der zumindest einen oberen Wärmequelle 51 erzeugte Wärme auf den zumindest einen deckelseitigen Kühlkörper 19 zu übertragen. Es wäre allerdings auch möglich, dass der zumindest eine deckelseitige Kühlkörper 19 direkt an der oberen Wärmequelle 51 anliegt, ohne dass ein Spalt dazwischen ausgebildet ist

Weiterhin ist zumindest ein bodenseitiger Kühlkörper 18 dargestellt, der sich in axialer Richtung vom Gehäuseboden 10 in Richtung des Gehäusedeckels 4 erstreckt. Der zumindest eine bodenseitige Kühlkörper 18 ist einteilig mit dem Gehäuseboden 10 ausgebildet. Wie innerhalb von Figur 7 dargestellt, liegt der zumindest eine bodenseitige Kühlkörper 18 wiederum über ein Wärmeleitmittel 20 an zumindest einer unteren Wärmequelle an. Die untere Wärmequelle ist in Figur 8 nicht dargestellt.

Bei der oberen bzw. unteren Wärmequelle 51 kann es sich um ein elektrisches Bauelement oder um ein Inlay (Hitzeverteiler) oder um eine Vielzahl von Durchkontaktierungen handeln. Unter einer Wärmequelle wird sowohl eine aktive Wärmequelle (z.B. Chip, Transistor) verstanden als auch eine passive Wärmequelle (Inlay, Durchkontaktierungen). Eine passive Wärmequelle wird über eine aktive Wärmequelle aufgeheizt. Die Kühlkörper 18, 19 dienen dazu die Wärme sowohl von der aktiven, als auch von der passiven Wärmequelle 51 abzuführen. Unter einer Wärmequelle werden einzig Bauteile verstanden, die auf der Leiterplatte 15 oder in der Leiterplatte 15 angeordnet sind. Die jeweiligen Kühlkörper 18, 19 sind vorzugsweise dicker als die jeweiligen Abstütztrennwände 13, 21. Der deckelseitige Kühlkörper 19 ist vorzugsweise überwiegend oder vollständig über dem bodenseitigen Kühlkörper 18 angeordnet.

Mit Hinblick auf Figur 3 ist ersichtlich, dass die bodenseitigen Hochfrequenzkammern 14 nur in einem Teil des Aufnahmeraums 12 des Hochfrequenzverstärkers 1 ausgebildet sind. Dies bedeutet, dass nicht der ganze Gehäuseboden 10 mit den bodenseitigen Hochfrequenzkammern 14 versehen ist. Der Zwischendeckel 8 und die Leiterplatte 15 erstrecken sich außerdem nur über den bodenseitigen Hochfrequenzkammern 14. Dies bedeutet, dass sich der Zwischendeckel 8 und Leiterplatte 15 vorzugsweise ebenfalls nicht über den gesamten Gehäuseboden 10 erstrecken. Nicht dargestellt ist ein Netzteil, welches in dem anderen Teil des Aufnahmeraums 12 angeordnet ist und welches auf dem Gehäuseboden 10 neben den bodenseitigen Hochfrequenzkammern 14 aufliegt. Dadurch, dass die bodenseitigen Hochfrequenzkammern 14 bereits vollumfänglich geschirmt sind, kann das Netzteil ungeschirmt verbaut werden. Dies erlaubt, dass die durch das Netzteil entstehende Wärme sehr effizient an dem Gehäuseboden 10 abgeführt werden kann. Zur weiteren Wärmeabfuhr weist der Hochfrequenzverstärker 1 mehrere bodenseitige Kühlrippen 41 auf. Diese sind in Figur 7 dargestellt.

Der Gehäuseboden 10 ist zusammen mit der umlaufenden Gehäusewand 11 in einem Druckgussverfahren (insbesondere Aluminiumdruckguss) und/oder in einem Fräsverfahren einteilig hergestellt. Gleiches kann ebenfalls für den Zwischendeckel 8 gelten.

Figur 5 ist außerdem noch zu entnehmen, dass der Zwischendeckel 8 zumindest eine, vorzugsweise mehrere, in Richtung des Gehäusedeckels 4 zeigende Öffnungen 29 aufweist, durch die sich zumindest ein Bauteil bzw. zumindest eine Steckkarte, das bzw. die auf der Leiterplatte 15 angeordnet sind, hindurcherstrecken können. Die Öffnungen 29 sind bezüglich ihrer Länge und Breite so bemessen, dass das Bauteil bzw. die Steckkarte herausschauen können allerdings gegen ein Verkippen geschützt sind. Dadurch wird vermieden, dass das Bauteil bzw. die Steckkarte beim Transport herausrutschen. Die Öffnungen 29 können bezüglich ihrer Form und Größe auch so kodiert sein, dass nur bestimmte Bauelemente bzw. Steckkarten in bestimmte Öffnungen 29 passen. So wird vermieden, dass Anschlusskontakte beschädigt werden, weil ein Bauteil bzw. eine Steckkarte in die falsche Öffnung 29 eingeführt wird. Eine Oberseite des Zwischendeckels 8, die in Richtung des Gehäusedeckels 4 zeigt, kann auch bedruckt sein, um Anschlussmöglichkeiten für die Bauelemente bzw. die Steckkarten anzuzeigen.

Die Erfindung ist nicht auf die beschriebenen Ausführungsbeispiele beschränkt. Im Rahmen der Erfindung sind alle beschriebenen und/oder gezeichneten Merkmale beliebig miteinander kombinierbar.

## Patentansprüche

1. Hochfrequenzverstärker (1) für Koaxialnetzwerke, wobei der Hochfrequenzverstärker (1) ein Hochfrequenzgehäuse (2) aufweist, das einen Gehäusekörper (3) und einen Gehäusedeckel (4) umfasst, mit den folgenden Merkmalen:
- der Gehäusekörper (3) weist einen Gehäuseboden (10) und eine zwischen dem Gehäuseboden (10) und dem Gehäusedeckel (4) umlaufende Gehäusewand (11) auf, wodurch ein Aufnahmeraum (12) gebildet ist und wodurch der Gehäusedeckel (4) von dem Gehäuseboden (10) des Gehäusekörpers (3) beabstandet ist;
- der Hochfrequenzverstärker (1) umfasst eine Leiterplatte (15), die mehrere elektrische Funktionseinheiten (16) aufweist;
- mehrere oberseitige Massebereiche (28) sind auf einer Oberseite (27) der Leiterplatte (15) zwischen den elektrischen Funktionseinheiten (16) angeordnet; **gekennzeichnet durch** die folgenden Merkmale:
- der Gehäusekörper (3) umfasst eine Vielzahl von bodenseitigen Abstütztrennwänden (13), die galvanisch mit dem Gehäuseboden (10) verbunden und einteilig mit diesem ausgebildet sind;
- die Vielzahl von bodenseitigen Abstütztrennwänden (13) erstrecken sich in axialer Richtung vom Gehäuseboden (10) in Richtung des Gehäusedeckels (4), wodurch mehrere bodenseitige Hochfrequenzkammern (14) gebildet sind;
- mehrere unterseitige Massebereiche (26) sind auf einer Unterseite (25) der Leiterplatte (15) zwischen den elektrischen Funktionseinheiten (16) angeordnet;
- die Leiterplatte (15) liegt überwiegend auf ihren unterseitigen Massebereichen (26) auf der Vielzahl von bodenseitigen Abstütztrennwänden (13) auf, wodurch die einzelnen elektrischen Funktionseinheiten (16) in Richtung des Gehäusebodens (10) durch die bodenseitigen Hochfrequenzkammern (14) voneinander getrennt sind;
- der Hochfrequenzverstärker (1) umfasst einen Zwischendeckel (8), der eine Vielzahl von deckelseitigen Abstütztrennwänden (21) umfasst, die galvanisch mit dem Zwischendeckel (8) verbunden und einteilig mit diesem ausgebildet sind;
- die Vielzahl von deckelseitigen Abstütztrennwänden (21) erstrecken sich in axialer Richtung von dem Zwischendeckel (8) in Richtung des Gehäusebodens (10), wodurch mehrere deckelseitige Hochfrequenzkammern (22) gebildet sind;
- die deckelseitigen Abstütztrennwände (21) des Zwischendeckels (8) liegen überwiegend auf den oberseitigen Massebereichen (28) der Leitplatte (15) auf, wodurch die einzelnen elektrischen Funktionseinheiten (16) in Richtung des Gehäusedeckels (4) durch die deckelseitigen Hochfrequenzkammern (22) voneinander getrennt sind.

2. Hochfrequenzverstärker nach Anspruch 1, **gekennzeichnet durch,** die folgenden Merkmale:
- die deckelseitigen Abstütztrennwände (21) und die bodenseitigen Abstütztrennwänden (13) sind überwiegend oder vollständig übereinander angeordnet, wodurch das Durchbiegen der Leiterplatte (15) reduziert oder unterbunden ist; und/oder
- die oberseitigen Massebereiche (28), auf denen die deckelseitigen Abstütztrennwände (21) anliegen und die unterseitigen Massebereiche (26), die auf den bodenseitigen Abstütztrennwänden (13) aufliegen sind überwiegend oder vollständig übereinander angeordnet, wodurch das Durchbiegen der Leiterplatte (15) reduziert oder unterbunden ist.

3. Hochfrequenzverstärker nach Anspruch 2, **gekennzeichnet durch,** das folgende Merkmal:
- eine Vielzahl von Durchkontaktierungen verbinden die oberseitigen Massebereiche (28) mit den unterseitigen Massebereichen (26) galvanisch.

4. Hochfrequenzverstärker nach einem der vorherigen Ansprüche, **gekennzeichnet durch,** das folgende Merkmal:
- mehrere Schraubverbindungen durchsetzen den Zwischendeckel (8) und die Leiterplatte (15) und enden im Gehäuseboden (10), wodurch der Zwischendeckel (8) mit seinen deckelseitigen Abstütztrennwänden (21) auf die Leiterplatte (15) gedrückt ist und die Leiterplatte (15) auf die bodenseitigen Abstütztrennwände (13) gedrückt ist.

5. Hochfrequenzverstärker nach einem der vorherigen Ansprüche, **gekennzeichnet durch,** die folgenden Merkmale:
- die Leiterplatte (15) liegt mit ihrem unterseitigen Umfangsbereich überwiegend oder vollumfänglich auf den bodenseitigen Abstütztrennwänden (13) und/oder auf einer Auflageschulter des Gehäusebodens (10) auf; und/oder
- der Zwischendeckel (8) liegt mit seinen deckelseitigen Abstütztrennwänden (21) überwiegend oder vollumfänglich auf einem oberseitigen Umfangsbereich der Leiterplatte (15) auf.

6. Hochfrequenzverstärker nach einem der vorherigen Ansprüche, **gekennzeichnet durch,** die folgenden Merkmale:
- alle unterseitigen Massebereiche (26) sind galvanisch über die gleiche Seite (25) der Leiterplatte (15) miteinander verbunden; und/oder
- alle oberseitigen Massebereiche (28) sind galvanisch über die gleiche Seite (27) der Leiterplatte (15) miteinander verbunden.

7. Hochfrequenzverstärker nach einem der vorherigen Ansprüche, **gekennzeichnet durch,** das folgende Merkmal:
- der Zwischendeckel (8) weist zumindest eine, in Richtung des Gehäusedeckels (4) zeigende Öffnung (29) auf, durch die sich zumindest ein Bauteil bzw. zumindest eine Steckkarte, das bzw. die auf der Leiterplatte (15) angeordnet ist, hindurch erstreckt und vorzugsweise gegen ein Verkippen geschützt ist.

8. Hochfrequenzverstärker nach einem der vorherigen Ansprüche, **gekennzeichnet durch,** die folgenden Merkmale:
- der Zwischendeckel (8) ist ausschließlich in dem Aufnahmeraum (12) angeordnet; und/oder
- die Leiterplatte (15) ist ausschließlich in dem Aufnahmeraum (12) angeordnet.

9. Hochfrequenzverstärker nach einem der vorherigen Ansprüche, **gekennzeichnet durch,** das folgende Merkmal:
- auf der Seite der Leiterplatte (15), auf der die überwiegende Anzahl der Bauteile angeordnet sind, sind die Abstütztrennwände (13, 21) bezogen auf die Leiterplatte (15) höher als auf der gegenüberliegenden Seite der Leiterplatte (15).

10. Hochfrequenzverstärker nach einem der vorherigen Ansprüche, **gekennzeichnet durch,** die folgenden Merkmale:
a)
- zumindest einige der elektrischen Funktionseinheiten (16), die in unterschiedlichen deckel- und/oder bodenseitigen Hochfrequenzkammern (22, 14) angeordnet sind, sind auf der Oberseite (27) der Leiterplatte (15) miteinander an zumindest einem oberseitigen Kontaktbereich elektrisch verbunden;
- an diesem zumindest einen oberseitigen Kontaktbereich weisen die oberseitigen Massebereiche (28) eine Unterbrechung (30) auf;
- an diesem zumindest einen oberseitigen Kontaktbereich weisen die deckelseitigen Abstütztrennwände (21) eine Ausnehmung (30) auf und sind von der Oberseite (27) der Leiterplatte (15) beabstandet;
- vorzugsweise alle bodenseitigen Abstütztrennwände (13) der bodenseitigen Hochfrequenzkammern (14) liegen unterbrechungsfrei auf der Unterseite (25) der Leiterplatte (15) an;
oder
b)
- zumindest einige der elektrischen Funktionseinheiten (16), die in unterschiedlichen deckel- und/oder bodenseitigen Hochfrequenzkammern (22, 14) angeordnet sind, sind auf der Unterseite (25) der Leiterplatte (15) miteinander an zumindest einem unterseitigen Kontaktbereich elektrisch verbunden;
- an diesem zumindest einen unterseitigen Kontaktbereich weisen die unterseitigen Massebereiche (26) eine Unterbrechung auf;
- an diesem zumindest einen unterseitigen Kontaktbereich sind die bodenseitigen Abstütztrennwände (13) von der Unterseite (25) der Leiterplatte (15) beabstandet;
- vorzugsweise alle deckelseitigen Abstütztrennwände (21) der deckelseitigen Hochfrequenzkammern (22) liegen unterbrechungsfrei auf der Oberseite (27) der Leiterplatte (15) an.

11. Hochfrequenzverstärker nach einem der vorherigen Ansprüche, **gekennzeichnet durch,** das folgende Merkmal:
- eine Steuereinheit ist auf der Leiterplatte (15) angeordnet und von einer deckel- und bodenseitigen Hochfrequenzkammer (22, 14) eingeschlossen, wobei die deckel- und bodenseitige Hochfrequenzkammer (22, 14) im Zentrum der anderen deckel- und bodenseitigen Hochfrequenzkammern (22, 14) liegt.

12. Hochfrequenzverstärker nach einem der vorherigen Ansprüche, **gekennzeichnet durch,** die folgenden Merkmale:
a)
- zumindest ein bodenseitiger Kühlkörper (18) erstreckt sich in axialer Richtung vom Gehäuseboden (10) in Richtung des Gehäusedeckels (4);
- der zumindest eine bodenseitige Kühlkörper (18) ist einteilig mit dem Gehäuseboden (10) ausgebildet;
- zumindest eine untere Wärmequelle ist an der Unterseite (25) der Leiterplatte (15) angeordnet;
- der zumindest eine bodenseitige Kühlkörper (18) liegt direkt an der zumindest einen unteren Wärmequelle (50) an und/oder der zumindest eine bodenseitige Kühlkörper (18) ist von der zumindest einen unteren Wärmequelle (50) durch einen Spalt beabstandet, wobei in diesen Spalt ein Wärmeleitmittel (20) eingebracht ist, um die von der zumindest einen unteren Wärmequelle (50) erzeugte Wärme an den zumindest einen bodenseitigen Kühlkörper (18) zu übertragen;
und/oder
b)
- zumindest ein deckelseitiger Kühlkörper (19) erstreckt sich in axialer Richtung vom Zwischendeckel (8) in Richtung des Gehäusebodens (10);
- der zumindest eine deckelseitige Kühlkörper (19) ist einteilig mit dem Zwischendeckel (8) ausgebildet;
- zumindest eine obere Wärmequelle (51) ist an der Oberseite (27) der Leiterplatte (15) angeordnet;
- der zumindest eine deckelseitige Kühlkörper (19) liegt direkt an der zumindest einen oberen Wärmequelle (51) an und/oder der zumindest eine deckelseitige Kühlkörper (19) ist von der zumindest einen oberen Wärmequelle (51) durch einen Spalt beabstandet, wobei in diesen Spalt ein Wärmeleitmittel (20) eingebracht ist, um die von der zumindest einen oberen Wärmequelle (51) erzeugte Wärme an den zumindest einen deckelseitigen Kühlkörper (19) zu übertragen.

13. Hochfrequenzverstärker nach Anspruch 12, **gekennzeichnet durch,** das folgende Merkmal:
- der zumindest eine deckelseitige Kühlkörper (19) und der zumindest eine bodenseitige Kühlkörper (18) sind überwiegend oder vollständig übereinander angeordnet.

14. Hochfrequenzverstärker nach einem der vorherigen Ansprüche, **gekennzeichnet durch,** das folgende Merkmal:
- die umlaufende Gehäusewand (11) weist mehrere Anschlussöffnungen (40) zum Anschluss von Koaxialkabeln und/oder Glasfaserkabeln auf, wobei in zumindest eine deckel- und/oder bodenseitige Hochfrequenzkammer (22, 14) zwei Anschlussöffnungen (40) münden, die in einem Winkel von in etwa 90° zueinander stehen.

15. Hochfrequenzverstärker nach einem der vorherigen Ansprüche, **gekennzeichnet durch,** die folgenden Merkmale:
- der Zwischendeckel (8), die Leiterplatte (15) und der Teil des Gehäusebodens (10), an dem die bodenseitigen Hochfrequenzkammern (14) ausgebildet sind, umfassen nur einen Teil des Aufnahmeraums (12) des Hochfrequenzverstärkers (1);
- ein Netzteil ist in einem anderen Teil des Aufnahmeraums (12) angeordnet und liegt auf dem Gehäuseboden (10) auf, wobei das Netzteil ungeschirmt ist.

16. Hochfrequenzverstärker nach einem der vorherigen Ansprüche, **gekennzeichnet durch,** die folgenden Merkmale:
- der Gehäuseboden (10) ist zusammen mit der umlaufenden Gehäusewand (11) in einem Druckgussverfahren und/oder Fräsverfahren einteilig hergestellt; und/oder
- der Zwischendeckel (8) ist in einem Druckgussverfahren und/oder Fräsverfahren einteilig hergestellt.

## Claims

1. High-frequency amplifier (1) for coaxial networks, the high-frequency amplifier (1) comprising a high-frequency housing (2) that includes a housing body (3) and a housing cover (4), having the following features:
- the housing body (3) comprises a housing base (10) and a peripheral housing wall (11) between the housing base (10) and the housing cover (4), as a result of which a receiving space (12) is formed, and as a result of which the housing cover (4) is spaced apart from the housing base (10) of the housing body (3);
- the high-frequency amplifier (1) includes a printed circuit board (15) comprising a plurality of electrical functional units (16);
- a plurality of top-side earth regions (28) are arranged on a top side (27) of the printed circuit board (15) between the electrical functional units (16);
**characterised by** the following features:
- the housing body (3) includes a plurality of base-side supporting partitions (13) that are galvanically connected to the housing base (10) and are integral therewith;
- the plurality of base-side supporting partitions (13) extend in the axial direction from the housing base (10) towards the housing cover (4), as a result of which a plurality of base-side high-frequency chambers (14) are formed;
- a plurality of bottom-side earth regions (26) are arranged on a bottom side (25) of the printed circuit board (15) between the electrical functional units (16);
- the printed circuit board (15) rests, predominately by means of the bottom-side earth regions (26) thereof, on the plurality of base-side supporting partitions (13), as a result of which the individual electrical functional units (16) are separated from one another towards the housing base (10) by the base-side high-frequency chambers (14);
- the high-frequency amplifier (1) includes an intermediate cover (8) which includes a plurality of cover-side supporting partitions (21) that are galvanically connected to the intermediate cover (8) and are integral therewith;
- the plurality of cover-side supporting partitions (21) extend in the axial direction from the intermediate cover (8) towards the housing base (10), as a result of which a plurality of cover-side high-frequency chambers (22) are formed;
- the cover-side supporting partitions (21) of the intermediate cover (8) rest predominately on the top-side earth regions (28) of the printed circuit board (15), as a result of which the individual electrical functional units (16) are separated from one another towards the housing cover (4) by the cover-side high-frequency chambers (22).

2. High-frequency amplifier according to claim 1, **characterised by** the following features:
- the cover-side supporting partitions (21) and the base-side supporting partitions (13) are arranged predominately or completely above one another, as a result of which bending of the printed circuit board (15) is reduced or prevented; and/or
- the top-side earth regions (28), on which the cover-side supporting partitions (21) rest, and the bottom-side earth regions (26), which rest on the base-side supporting partitions (13), are arranged predominately or completely above one another, as a result of which bending of the printed circuit board (15) is reduced or prevented.

3. High-frequency amplifier according to claim 2, **characterised by** the following feature:
- a plurality of vias galvanically connect the top-side earth regions (28) to the bottom-side earth regions (26).

4. High-frequency amplifier according to any of the preceding claims, **characterised by** the following feature:
- a plurality of screw connections penetrate the intermediate cover (8) and the printed circuit board (15) and terminate in the housing base (10), as a result of which the intermediate cover (8) is pressed onto the printed circuit board (15) by means of the cover-side supporting partitions (21) thereof and the printed circuit board (15) is pressed onto the base-side supporting partitions (13).

5. High-frequency amplifier according to any of the preceding claims, **characterised by** the following features:
- the printed circuit board (15) rests predominately or completely on the base-side supporting partitions (13) and/or on a bearing shoulder of the housing base (10) by means of the bottom-side peripheral region thereof; and/or
- the intermediate cover (8) rests predominately or completely on a top-side peripheral region of the printed circuit board (15) by means of the cover-side supporting partitions (21) thereof.

6. High-frequency amplifier according to any of the preceding claims, **characterised by** the following features:
- all of the bottom-side earth regions (26) are galvanically interconnected by the same side (25) of the printed circuit board (15); and/or
- all of the top-side earth regions (28) are galvanically interconnected by the same side (27) of the printed circuit board (15); and/or

7. High-frequency amplifier according to any of the preceding claims, **characterised by** the following feature:
- the intermediate cover (8) comprises at least one opening (29) positioned towards the housing cover (4), through which opening at least one component or at least one plug-in card arranged on the printed circuit board (15) extends and is preferably protected from tilting.

8. High-frequency amplifier according to any of the preceding claims, **characterised by** the following features:
- the intermediate cover (8) is arranged exclusively in the receiving space (12); and/or
- the printed circuit board (15) is arranged exclusively in the receiving space (12).

9. High-frequency amplifier according to any of the preceding claims, **characterised by** the following feature:
- on the side of the printed circuit board (15) on which the predominant number of components are arranged, the supporting partitions (13, 21) are higher with respect to the printed circuit board (15) than on the opposite side of the printed circuit board (15).

10. High-frequency amplifier according to any of the preceding claims, **characterised by** the following features:
a)
- at least some of the electrical functional units (16), which are arranged in various cover- and/or base-side high-frequency chambers (22, 14), are electrically interconnected at at least one top-side contact region on the top side (27) of the printed circuit board (15);
- the top-side earth regions (28) comprise a break (30) at said at least one top-side contact region;
- the cover-side supporting partitions (21) comprise a recess (30) and are spaced apart from the top side (27) of the printed circuit board (15) at said at least one top-side contact region;
- preferably all of the base-side supporting partitions (13) of the base-side high-frequency chambers (14) rest on the bottom side (25) of the printed circuit board (15) without any breaks; or
b)
- at least some of the electrical functional units (16), which are arranged in various cover- and/or base-side high-frequency chambers (22, 14), are electrically interconnected at at least one bottom-side contact region on the bottom side (25) of the printed circuit board (15);
- the bottom-side earth regions (26) comprise a break at said at least one bottom-side contact region;
- the base-side supporting partitions (13) are spaced apart from the bottom side (25) of the printed circuit board (15) at said at least one bottom-side contact region;
- preferably all of the cover-side supporting partitions (21) of the cover-side high-frequency chambers (22) rest on the top side (27) of the printed circuit board (15) without any breaks.

11. High-frequency amplifier according to any of the preceding claims, **characterised by** the following feature:
- a control unit is arranged on the printed circuit board (15) and is enclosed by a cover- and base-side high-frequency chamber (22, 14), the cover- and base-side high-frequency chambers (22, 14) being positioned in the middle of the other cover- and base-side high-frequency chambers (22, 14).

12. High-frequency amplifier according to any of the preceding claims, **characterised by** the following features:
a)
- at least one base-side cooling body (18) extends in the axial direction from the housing base (10) towards the housing cover (4);
- the at least one base-side cooling body (18) is integral with the housing base (10);
- at least one lower heat source is arranged on the bottom side (25) of the printed circuit board (15);
- the at least one base-side cooling body (18) rests directly on the at least one lower heat source (50) and/or the at least one base-side cooling body (18) is spaced apart from the at least one lower heat source (50) by a gap, a heat-conducting means (20) being inserted into said gap in order to transfer the heat generated by the at least one lower heat source (50) to the at least one base-side cooling body (18);
and/or
b)
- at least one cover-side cooling body (19) extends in the axial direction from the intermediate cover (8) towards the housing base (10);
- the at least one cover-side cooling body (19) is integral with the intermediate cover (8);
- at least one upper heat source (51) is arranged on the top side (27) of the printed circuit board (15);
- the at least one cover-side cooling body (19) rests directly on the at least one upper lower heat source (51) and/or the at least one cover-side cooling body (19) is spaced apart from the at least one upper heat source (51) by a gap, a heat-conducting means (20) being inserted into said gap in order to transfer the heat generated by the at least one upper heat source (51) to the at least one cover-side cooling body (19).

13. High-frequency amplifier according to claim 12, **characterised by** the following feature:
- the at least one cover-side cooling body (19) and the at least one base-side cooling body (18) are arranged predominately or completely above one another.

14. High-frequency amplifier according to any of the preceding claims, **characterised by** the following feature:
- the peripheral housing wall (11) comprises a plurality of connection openings (40) for connecting coaxial cables and/or fibre optic cables, two connection openings (40) that are at an angle of approximately 90° to one another opening into at least one cover- and/or base-side high-frequency chamber (22, 14).

15. High-frequency amplifier according to any of the preceding claims, **characterised by** the following features:
- the intermediate cover (8), the printed circuit board (15) and the part of the housing base (10) on which the base-side high-frequency chambers (14) are formed take up only part of the receiving space (12) of the high-frequency amplifier (1);
- a power supply unit is arranged in another part of the receiving space (12) and rests on the housing base (10), the power supply unit being unshielded.

16. High-frequency amplifier according to any of the preceding claims, **characterised by** the following features:
- the housing base (10) is produced in one piece together with the peripheral housing wall (11) in a die casting process and/or milling process; and/or
- the intermediate cover (8) is produced in one piece in a die casting process and/or milling process.

## Revendications

1. Amplificateur de haute fréquence (1) pour des réseaux coaxiaux, l'amplificateur de haute fréquence (1) comportant un boîtier à hautes fréquences (2), qui comprend un corps de boîtier (3) et un couvercle de boîtier (4), ayant les caractéristiques suivantes :
- le corps de boîtier (3) présente un fond de boîtier (10) et une paroi de boîtier (11) en rotation entre le fond de boîtier (10) et le couvercle de boîtier (4), un espace de réception (12) étant ainsi créé et le couvercle de boîtier (4) étant espacé du fond de boîtier (10) du corps de boîtier (3) ;
- l'amplificateur de haute fréquence (1) comprend une carte à circuit imprimé (15), qui comporte plusieurs unités fonctionnelles électriques (16) ;
- plusieurs régions de masse supérieures (28) sont disposées sur une face supérieure (27) de la carte à circuit imprimé (15) entre les unités fonctionnelles électriques (16) ; **caractérisé par** les caractéristiques suivantes :
- le corps de boîtier (3) comprend une pluralité de parois séparatrices de support côté fond (13) qui sont reliées galvaniquement au fond de boîtier (10) et sont formées d'un seul tenant avec celui-ci ;
- la pluralité de parois séparatrices de support côté fond (13) s'étendent dans une direction axiale du fond de boîtier (10) au couvercle de boîtier (4), plusieurs chambres à hautes fréquences côté fond (14) étant ainsi créées ;
- plusieurs régions de masse inférieures (26) sont disposées sur une face inférieure (25) de la carte à circuit imprimé (15) entre les unités fonctionnelles électriques (16);
- la carte à circuit imprimé (15) se situe principalement sur ses régions de masse inférieures (26) sur la pluralité de parois séparatrices de support côté fond (13), chacune des unités fonctionnelles électriques (16) étant ainsi séparées les unes des autres vers le fond de boîtier (10) par les chambres à hautes fréquences côté fond (14);
- l'amplificateur de haute fréquence (1) comprend un couvercle intermédiaire (8) qui comprend une pluralité de parois séparatrices de support côté couvercle (21) qui sont galvaniquement reliées au couvercle intermédiaire (8) et sont formées d'un seul tenant avec celui-ci ;
- la pluralité de parois séparatrices côté couvercle (21) côté couvercle s'étendent dans une direction axiale du couvercle intermédiaire (8) au fond de boîtier (10), plusieurs chambres à hautes fréquences côté couvercle (22) étant ainsi créées ;
- les parois séparatrices côté couvercle (21) du couvercle intermédiaire (8) se situent principalement sur les régions de masse supérieures (28) de la carte à circuit imprimé (15), chacune des unités fonctionnelles électriques (16) étant ainsi séparées les unes des autres en direction du couvercle de boîtier (4) par le biais des chambres à hautes fréquences côté couvercle (22).

2. Amplificateur de haute fréquence selon la revendication 1, **caractérisé par** les caractéristiques suivantes :
- les parois séparatrices de support côté couvercle (21) et les parois séparatrices de support côté fond (13) sont disposées principalement ou complètement les unes au-dessus des autres, la flexion de la carte à circuit imprimé (15) étant ainsi réduite ou interrompue ; et/ou
- les régions de masse supérieures (28) sur lesquelles les parois séparatrices de support côté couvercle (21) reposent et les régions de masse inférieures (26) qui reposent sur les parois séparatrices de support côté fond (13) sont principalement ou complètement disposées les unes au-dessus des autres, la flexion de la carte à circuit imprimé (15) étant ainsi réduite ou interrompue.

3. Amplificateur de haute fréquence selon la revendication 2, **caractérisé par** la caractéristique suivante :
- une pluralité de connexions transversales relient galvaniquement les régions de masse supérieures (28) aux régions de masse inférieures (26).

4. Amplificateur de haute fréquence selon l'une des revendications précédentes, **caractérisé par** la caractéristique suivante :
- plusieurs assemblages vissés traversent le couvercle intermédiaire (8) et la carte à circuit imprimé (15) et se terminent dans le fond de boîtier (10), le couvercle intermédiaire (8) étant ainsi pressé avec ses parois séparatrices de support côté couvercle (21) sur la carte à circuit imprimé (15) et la carte à circuit imprimé (15) étant pressée sur les parois séparatrices de support côté fond (13).

5. Amplificateur de haute fréquence selon l'une des revendications précédentes, **caractérisé par** les caractéristiques suivantes :
- la carte à circuit imprimé (15) repose avec sa zone périphérique inférieure principalement ou entièrement sur les parois séparatrices de support côté fond (13) et/ou sur un épaulement d'appui du fond de boîtier (10) ; et/ou
- le couvercle intermédiaire (8) repose avec ses parois séparatrices de support côté couvercle (21) principalement ou entièrement sur une zone périphérique supérieure de la carte à circuit imprimé (15).

6. Amplificateur de haute fréquence selon l'une des revendications précédentes, **caractérisé par** les caractéristiques suivantes :
- toutes les régions de masse inférieures (26) sont reliées galvaniquement les unes aux autres sur le même côté (25) de la carte à circuit imprimé (15) ; et/ou
- toutes les régions de masse supérieures (28) sont reliées galvaniquement les unes aux autres sur le même côté (27) de la carte à circuit imprimé (15).

7. Amplificateur de haute fréquence selon l'une des revendications précédentes, **caractérisé par** la caractéristique suivante :
- le couvercle intermédiaire (8) présente au moins une ouverture (29) dirigée vers le couvercle de boîtier (4) à travers laquelle au moins un composant ou au moins une carte enfichable, qui est agencé sur la carte à circuit imprimé (15) s'étend ou est de préférence protégé contre un basculement.

8. Amplificateur de haute fréquence selon l'une des revendications précédentes, **caractérisé par** les caractéristiques suivantes :
- le couvercle intermédiaire (8) est disposé uniquement dans l'espace de réception (12) ; et/ou
- la carte à circuit imprimé (15) est disposée uniquement dans l'espace de réception (12).

9. Amplificateur de haute fréquence selon l'une des revendications précédentes, **caractérisé par** la caractéristique suivante :
- sur le côté de la carte à circuit imprimé (15), sur lequel la majeure partie des composants est disposée, les parois séparatrices de support (13, 21) sont plus élevées par rapport à la carte à circuit imprimé (15) que sur le côté opposé de la carte à circuit imprimé (15).

10. Amplificateur de haute fréquence selon l'une des revendications précédentes, **caractérisé par** les caractéristiques suivantes :
a)
- au moins certaines des unités fonctionnelles électriques (16), qui sont disposées dans différentes chambres à hautes fréquences côté couvercle et/ou fond (22, 14), sont reliées électriquement sur le côté supérieur (27) de la carte à circuit imprimé (15) les unes aux autres sur au moins une zone de contact électrique supérieure ;
- les régions de masse supérieures (28) présentent une interruption (30) sur ladite au moins une zone de contact supérieure ;
- les parois séparatrices de support côté couvercle (21) présentent un évidement (30) sur ladite au moins une zone de contact supérieure et sont espacées de la face supérieure (27) de la carte à circuit imprimé (15) ;
- de préférence toutes les parois séparatrices de support côté fond (13) des chambres à hautes fréquences côté fond (14) sont appliquées sans interruption sur la face inférieure (25) de la carte à circuit imprimé (15) ;
ou
b)
- au moins certaines des unités fonctionnelles électriques (16) qui sont disposées dans différentes chambres à hautes fréquences côté couvercle et/ou côté fond (22, 14) sont reliées ensemble électriquement sur la face inférieure (25) de la carte à circuit imprimé (15) sur au moins une zone de contact électrique inférieure ;
- les régions de masse inférieures (26) présentent sur ladite au moins une zone de contact inférieure une interruption ;
- les parois séparatrices de support côté fond (13) sont espacées sur ladite au moins une zone de contact inférieure de la face inférieure (25) de la carte à circuit imprimé (15) ;
- de préférence toutes les parois séparatrices de support côté couvercle (21) des chambres à hautes fréquences côté couvercle (22) sont appliquées sans interruption sur la face supérieure (27) de la carte à circuit imprimé (15).

11. Amplificateur de haute fréquence selon l'une des revendications précédentes, **caractérisé par** la caractéristique suivante :
- une unité de commande est disposée sur la carte à circuit imprimé (15).et est enfermée par une chambre à hautes fréquences côté couvercle et côté fond (22, 14), la chambre à hautes fréquences côté couvercle et côté fond (22, 14) étant située au centre des autres chambres à hautes fréquences côté couvercle et côté fond (22, 14).

12. Amplificateur de haute fréquence selon l'une des revendications précédentes, **caractérisé par** les caractéristiques suivantes :
a)
- au moins un dissipateur thermique côté fond (18) s'étend dans une direction axiale du fond de boîtier (10) au couvercle de boîtier (4) ;
- l'au moins un dissipateur thermique côté fond (18) est formé d'un seul tenant avec le fond de boîtier (10) ;
- au moins une autre source de chaleur inférieure est disposée sur la face inférieure (25) de la carte à circuit imprimé (15) ;
- l'au moins un dissipateur thermique côté fond (18) est situé directement sur l'au moins une source de chaleur inférieure (50) et/ou l'au moins un dissipateur thermique côté fond (18) est espacé de l'au moins une source de chaleur inférieure (50) par une fente, un moyen de conduction thermique (20) étant amené dans cette fente pour transmettre la chaleur produite par l'au moins une source de chaleur inférieure (50) sur l'au moins un dissipateur thermique côté fond (18) ;
et/ou
b)
- au moins un dissipateur thermique côté couvercle (19) s'étend dans une direction axiale du couvercle intermédiaire (8) vers le fond de boîtier (10) ;
- l'au moins un dissipateur thermique côté couvercle (19) est formé d'un seul tenant avec le couvercle intermédiaire (8) ;
- au moins une source de chaleur supérieure (51) est située sur la face supérieure (27) de la carte à circuit imprimé (15) ;
- l'au moins un dissipateur thermique côté couvercle (19) est appliqué directement contre l'au moins une source de chaleur supérieure (51) et/ou l'au moins un dissipateur thermique côté couvercle (19) est espacé de l'au moins une source de chaleur supérieure (51) par une fente, un moyen de conduction thermique (20) étant amené dans cette fente pour transmettre la chaleur produite par l'au moins une source de chaleur supérieure (51) sur l'au moins un dissipateur thermique côté couvercle (19).

13. Amplificateur de haute fréquence selon la revendication 12, **caractérisé par** la caractéristique suivante :
- l'au moins un dissipateur thermique côté couvercle (19) et l'au moins un dissipateur thermique côté fond (18) sont disposés principalement ou complètement l'un sur l'autre.

14. Amplificateur de haute fréquence selon l'une des revendications précédentes, **caractérisé par** la caractéristique suivante :
- la paroi de boîtier rotative (11) présente plusieurs orifices de raccordement (40) pour le raccordement de câbles coaxiaux et/ou de câbles à fibres optiques, deux orifices de raccordement (40) débouchant dans au moins une chambre à hautes fréquences côté couvercle et/ou fond (22, 14), lesquels sont situés à un angle d'environ 90° l'un de l'autre.

15. Amplificateur de haute fréquence selon l'une des revendications précédentes, **caractérisé par** les caractéristiques suivantes :
- le couvercle intermédiaire (8), la carte de circuit imprimé (15) et la partie du fond de boîtier (10), sur lequel les chambres à hautes fréquences côté fond (14) sont formées, comprennent seulement une partie de l'espace de réception (12) de l'amplificateur de haute fréquence (1) ;
- une partie de réseau est disposée dans une autre partie de l'espace de réception (12) et est située sur le fond de boîtier (10), la partie de réseau n'étant pas blindée.

16. Amplificateur de haute fréquence selon l'une des revendications précédentes, **caractérisé par** les caractéristiques suivantes :
- le fond de boîtier (10) est réalisé d'un seul tenant avec la paroi de boîtier rotative (11) dans un procédé de coulée sous pression et/ou un procédé de fraisage ; et/ou
- le couvercle intermédiaire (8) est réalisé d'un seul tenant dans un procédé de coulée sous pression et/ou un procédé de fraisage.
